# EUROPÄISCHE PATENTSCHRIFT

(11) **EP 1 701 167 B1**
(45) Veröffentlichungstag und Bekanntmachung des Hinweises auf die Patenterteilung: **19.10.2016**
(21) Anmeldenummer: 06002656.4
(22) Anmeldetag: 09.02.2006
(51) Int. Cl.: G01R 29/08, G01R 23/16, G01R 31/00

(54) **Verfahren und Vorrichtung zur Identifizierung von Funkstörpegeln asynchron zur Messung des Frequenzspektrums**
Method and device for identifying radio interference levels asynchronous to frequency spectrum measurement
Procédé et dispositif destinés à l'identification de niveaux de bruits parasites de manière asynchrone par rapport à la mesure du spectre de fréquence

(30) Priorität: 09.03.2005 DE 102005010882
(43) Veröffentlichungstag der Anmeldung: 13.09.2006
(73) Patentinhaber: Rohde & Schwarz GmbH & Co. KG, 81671 München (DE)
(72) Erfinder: Keller, Matthias, 85551 Kirchheim (DE)
(74) Vertreter: Körfer, Thomas

(56) Entgegenhaltungen:
- DE-C1- 3 817 500
- US-A- 4 501 020
- US-B1- 6 509 742

## Beschreibung

Die Erfindung betrifft ein Verfahren und eine Vorrichtung zur Identifizierung von Funkstörpegeln asynchron zur Spektrumanalyse.

Die Verwendung immer höherer Übertragungsfrequenzen im Mobilfunk und immer höherer Taktfrequenzen in der Datentechnik stellen zunehmend höhere Anforderungen an die elektromagnetische Verträglichkeit (EMV) vom elektronischen Geräten und Systemen in diesen Anwendungsfeldern. Als wesentliche Voraussetzung für eine optimierte EMVgerechte Auslegung entsprechender elektronischer Geräte und Systeme ist eine hochwertige EMV-Meßtechnik zur präzisen und zuverlässigen Identifizierung und Charakterisierung von auftretenden elektromagnetischen Störungen zu sehen.

Neben einer hohen Meßgenauigkeit in einer hohen Bandbreite bis in den Höchstfrequenzbereich sind vor allen fortgeschrittene Meßfunktionen, wie beispielsweise Signalstatistik, Messung von Leistung und Rauschen im Zeit- und Frequenzbereich, wesentliche Anforderungen an eine hochwertige EMV-Meßtechnik.

Während Spektrum-Analysatoren ihre Stärke in der EMV-Messung hauptsächlich in der schnellen Frequenzmessung bis in den Höchstfrequenzbereich besitzen, liegt der Anwendungsschwerpunkt von Meßempfängern eher in der hoch genauen Berechnung von rechenintensiven Meßfunktionen.

In der systemtechnischen Kombination von Spektrum-Analysator und Meßempfänger in einem EMV-Meßplatz können die jeweiligen Stärken der beiden Geräte in einem System gebündelt werden. In der DE 38 17 500 C1 ist ein derartiges System dargestellt, in dem über eine Spektrum-Analysator-Funktion der gewünschte Meßfrequenzbereich durchgestimmt und bei jeder Meßfrequenz der gemessene Spannungspegel mit einem Grenzwert verglichen und bei Überschreitung des Grenzwertes durch den gemessenen Spannungspegel der zur Meßfrequenz gehörige Spannungspegel als Funkstörspannung gekennzeichnet wird. Sobald eine Funkstörspannung auf diese Weise identifiziert wird, erfolgt eine Umschaltung von der Spektrum-Analysator-Funktion zur Meßempfänger-Funktion. In der Meßempfänger-Funktion wird die Funkstörpannung bei der jeweiligen Meßfrequenz mehrfach hinsichtlich ihres Spannungspegels abgetastet und bei ausgewählter statistischer Bewertungsfunktion hinsichtlich ihres Zeitverhaltens exakter charakterisiert.

Das Dokument US6509742 beschreibt eine Vorrichtung und ein Verfahren zur EMV-Messung.

Nachteilig an dieser systemtechnischen Kombination von Spektrum-Analysator und Meßempfänger ist die synchron zur Frequenz-Durchstimmung und zur Spannungspegel-Messung durchgeführte Identifizierung von Funkstörpegeln und darauf aufsetzende Nachmessung, die dem Anwender des EMV-Meßsystems die Möglichkeit des manuellen Identifizierens von Funkstörpegeln im gewünschten Meßfrequenzbereich mittels Handabstimmung versagt.

Der Erfindung liegt daher die Aufgabe zugrunde, ein Verfahren und eine Vorrichtung zur Messung von Funkstörpegeln derart weiterzuentwickeln, daß dem Anwender eine manuelle Identifizierung von Funkstörpegeln im gewünschten Meßfrequenzbereich ermöglicht wird.

Die Aufgabe der Erfindung wird durch ein Verfahren und eine Vorrichtung zur Messung von Funkstörpegeln mit den Merkmalen des Anspruchs 1 bzw. des Anspruchs 8 gelöst.
Vorteilhafte Weiterbildungen der Erfindung sind in den abhängigen Ansprüchen aufgeführt.

Indem der Spektrum-Analysator im Rahmen der Vormessung den gesamten gewünschten Meßfrequenzbereich zyklisch in einem bestimmten Frequenzraster durchgestimmt und bei jeder Meßfrequenz der jeweilige Spannungspegel des zu messenden Signals erfaßt wird, werden die Spannungspegel des zu messenden Signals zu den einzelnen Meßfrequenzen des Meßfrequenzbereiches ständig aktualisiert. Diese kontinuierliche Aktualisierung der Spannungspegel in kurzen Zeitintervallen ist zwingende Voraussetzung für eine vom Anwender des EMV-Meßsystems zu einem beliebigen Zeitpunkt und damit asynchron zur Meßfrequenzbereichs-Durchstimmung und -Messung durchzuführende Identifizierung von Funkstörpegeln.

In einer ersten bevorzugten Ausführungsform des erfindungsgemäßen Verfahrens und der erfindungsgemäßen Vorrichtung zur Messung von Funkstörpegeln werden die einzelnen Funkstörpegel im kontinuierlich gemessenen Frequenzspektrum manuell während der Vormessung identifiziert. Hierzu stimmt der Anwender das vom Spektrum-Analysator kontinuierlich gemessene Frequenzspektrum während der Vormessung händisch durch und kennzeichnet im Rahmen einer visuellen Sichtung des gemessenen Frequenzspektrums auftretende Funkstörpegel, deren mittlere Frequenz nach der Kennzeichnung durch den Anwender vom Spektrum-Analysator noch während der Vormessung gemessen wird. Nach Ermittlung der Frequenz des Funkstörpegels wird die Vormessung des Spektrum-Analysators unterbrochen und auf einen Meßempfänger umgeschaltet, mit dem im Rahmen einer Nachmessung in mehreren Meßzyklen der jeweilige Funkstörpegel wiederholt gemessen und eine statistische Auswertung ausgeführt wird. Nach Durchführung der zum jeweiligen Funkstörpegel gehörigen Auswertung wird wieder zum Spektrum-Analysator umgeschaltet, in dem im Rahmen der Vormessung der gewünschte Meßfrequenzbereich zyklisch durchgestimmt und die Spannungspegel zu den einzelnen Frequenzrasterpunkten gemessen werden. Mit wiederholter Einsetzung der Vormessung kann der Anwender den Meßfrequenzbereich nach weiteren Funkstörpegeln untersuchen.

In einer zweiten Ausführungsform des erfindungsgemäßen Verfahrens und der erfindungsgemäßen Vorrichtung zur Messung von Funkstörpegeln wird auf Wunsch des Anwenders die asynchron zur Durchstimmung und Messung des Meßfrequenzbereiches während der Vormessung durchzuführende Identifizierung von Funkstörpegeln durch eine Vergleichs-Einheit des Spektrum-Analysators automatisiert durchgeführt. Hierzu vergleicht die Vergleichs-Einheit jeden einzelnen der gemessenen Spannungspegel mit einem Schwellwert und kennzeichnet bei Überschreitung des Schwellwerts durch einen der gemessenen Spannungspegel diesen Spannungspegel als Funkstörpegel. Analog zur ersten Ausführungsform wird für diesen derart identifizierten Funkstörpegel vom Spektrum-Analysator die zugehörige Frequenz ermittelt und auf den Meßempfänger zur detaillierten Messung und Auswertung des Funkstörpegels im Rahmen der Nachmessung umgeschaltet.

Indem vom Spektrum-Analysator die für jeden identifizierten Funkstörpegel gemessene mittlere Frequenz dem Meßempfänger für die Nachmessung übergeben wird, ist gewährleistet, daß der beschränkte Meßfrequenzbereich des Meßempfängers an die aktuelle Frequenz der jeweiligen Funkstörspannung angepaßt wird und die jeweils identifizierte Funkstörspannung mittig zum Meßfrequenzbereich des Meßempfängers im Hinblick auf eine korrekte Zeitanalyse zu liegen kommt.

Neben der hoch aktualisierten Erfassung der Frequenz der Funkstörspannung kann das erfindungsgemäße Verfahren bzw. die erfindungsgemäße Vorrichtung zur Messung von Funkstörspannungen auch zeitliche Änderungen der Spannungspegels der Funkstörspannung aktuell identifizieren und bei der Auswertung durch den Meßempfänger korrekt berücksichtigen. Auf diese Weise ist eine weitgehend aktualisierte Erfassung und Auswertung von frequenz- und amplitudenveränderlichen Funkstörspannungen durch das erfindungsgemäße Verfahren bzw. durch die erfindungsgemäße Vorrichtung zur Messung von Funkstörspannungen möglich.

Ein weiterer Vorteil des erfindungsgemäßen Verfahrens und der erfindunggemäßen Vorrichtung zur Messung von Funkstörpegeln ist zeitunabhängigen - einzig von der Identifizierungs- und Analyse-Geschwindigkeit des Anwenders bestimmten - Identifizierung der einzelnen Funkstörpegel zu sehen.

In dem Meßempfänger sind vorzugsweise mehrere auswählbare Bewertungsfunktionen integriert, mit denen in der Nachmessung eine exaktere Analyse des Zeitverhaltens der Funkstörspannung über eine gegenüber der Meßzeit des Spektrum-Analysators deutlich längeren Auswertezeit möglich ist.

Die beide Ausführungsformen der Erfindung sind in der Zeichnung dargestellt und werden nachfolgend näher beschrieben. Es zeigen:
- Fig. 1: ein Schaltbild einer ersten bevorzugten Ausführungsform einer erfindungsgemäßen Vorrichtung zur Messung von Funkstörpegeln;
- Fig. 2: ein Schaltbild einer zweiten Ausführungsform einer erfindungsgemäßen Vorrichtung zur Messung von Funkstörpegeln;
- Fig. 3: ein Flußdiagramm einer ersten Ausführungsform des erfindungsgemäßen Verfahrens zur Messung von Funkstörpegeln,
- Fig. 4: ein Flußdiagramm einer zweiten Ausführungsform des erfindungsgemäßen Verfahrens zur Messung von Funkstörpegeln,
- Fig. 5: eine grafische Darstellung eines beispielhaften Ergebnisses des erfindungsgemäßen Verfahrens bzw. einer erfindungsgemäßen Vorrichtung zur Messung von Funkstörspannungen und
- Fig.6: eine tabellarische Darstellung eines beispielhaften Ergebnisses des erfindungsgemäßen Verfahrens bzw. einer erfindungsgemäßen Vorrichtung zur Messung von Funkstörspannungen.

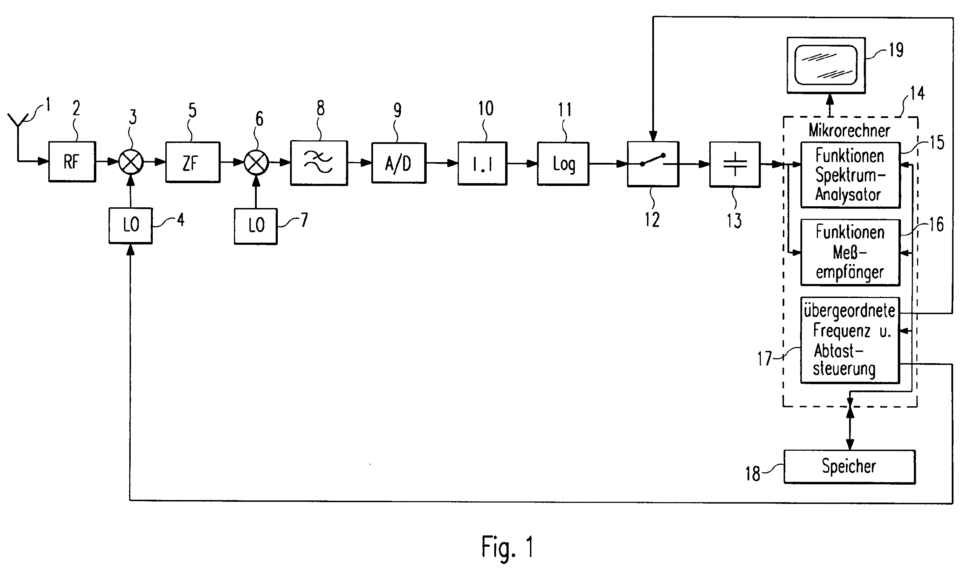

Das erfindungsgemäße Verfahren bzw. die erfindungsgemäße Vorrichtung zur Messung von Funkstörspannungen ist in den Figuren 1 bis 4 dargestellt.

In dieser Anmeldung wurden die Begriffe Funkstörpegel und Meßpegel allgemeingültig verwendet. Gemeint ist nicht nur die Funkstörspannung im engeren Sinne als Meßgröße, sondern auch andere Meßgrößen wie Feldstärke, Ströme usw., die das Meßsignal kennzeichnen. Der Begriff Pegel, Meßpegel bzw. Funkstörpegel kann daher beliebig durch Spannung, Meßspannung, Funkstörspannung usw. ersetzt werden.

Wie in Fig. 1 dargestellt, wird über eine Antenne 1 der ersten bevorzugten Ausführungsform der erfindungsgemäßen Vorrichtung zur Messung von Funkstörpegeln, die an einem bestimmten auswählbaren Meßort positioniert ist, jedes beliebige Nutz- und/oder Störsignal empfangen. Unter der Voraussetzung, daß die erfindungsgemäße Vorrichtung zur Messung von Funkstörpegeln an einem Meßort positioniert ist, an dem keine Nutzsignale auftreten, wird von der Antenne 1 im ungestörten Betriebsfall nur ein Rauschsignal empfangen. Bei Auftreten einer Funkstörung wird diese von einem Hochfrequenzteil 2 über die Antenne 1 empfangen.

Im sich anschließenden ersten Mischer 3 erfolgt eine Umsetzung auf die Zwischenfrequenz. Hierzu wird ein in seiner Frequenz verstimmbarer erster lokaler Oszillator 4 über den gesamten Meßfrequenzbereich der erfindungsgemäßen Vorrichtung vorzugsweise in einem bestimmten einstellbaren Frequenzraster durchgestimmt. Mit diesem in einem bestimmten Frequenzraster innerhalb des vorgegebenen Meßfrequenzbereiches durchgestimmten ersten lokaler Oszillator 4 wird im ersten Mischer 3 das Frequenzspektrum der empfangenen hochfrequenten Funkstörspannung zusammen mit der überlagerten hochfrequenten Rauschspannung in einen Zwischenfrequenzbereich umgesetzt.

In der Zwischenfrequenzeinheit 5 erfolgen mit dem Zwischenfrequenzsignal unterschiedliche Signalverarbeitungsfunktionen (z.B. Filterung, Linearisierung usw.). Die Umsetzung des Zwischenfrequenzsignals in das Basisband wird im darauf folgenden zweiten Mischer 6 durchgeführt. Die Trägerfrequenz zur Umsetzung in das Basisband wird von einem zweiten lokalen Oszillator 7 mit fixer Frequenz erzeugt.

In einem sich anschließenden Tiefpaßfilter 8 erfolgt eine Bereinigung des Basisbandsignals von unerwünschten höherfrequenten Anteilen, die außerhalb des Meßfrequenzbereiches bzw. evtl. ausgewählter Untermeßfrequenzbereiche liegen. Im Analog-/Digital-Wandler 9 wird die analoge Meßspannung in das digitale Datenformat transformiert. Die Betragsbildung der digitalisierten zeitveränderlichen Meßspannung wird im Betragsbildner 10 durchgeführt. Eine Logarithmierung der digitalisierten zeitveränderlichen Meßspannung für eine halblogarithmische Darstellung des Meßergebnisses erfolgt im Logarithmierer 11.

Der Zugriff auf das Signal ist durch den symbolischen Schalter 12 veranschaulicht. Hierzu erhält der Schalter 12 von einer übergeordneten Steuerung 17 ein Steuersignal, das den Zeitpunkt des Zugriffs bestimmt. Der digitalisierte Spannungspegel der Meßspannung wird während des Zugriffs in einem Detektor 13 erfaßt.

Der mit dem Detektor 13 erfaßte digitalisierte Spannungspegel der Meßspannung wird vom Mikrorechner 14 eingelesen. Mittels der Funktionseinheit Spektrum-Analysator 15 des Mikrorechner 14 wird die aus der Funkstörspannung und der überlagerten Rauschspannung bestehende Meßspannung über den gesamten einstellbaren Meßfrequenzbereich im einstellbaren Frequenzraster gemessen. Hierzu wird durch die übergeordnete Frequenz- und Abtaststeuereinheit 17 des Mikrorechners 14 die Frequenz des ersten Oszillators 4 über den einstellbaren Meßfrequenzbereich im einstellbaren Frequenzraster im Hinblick auf die Aufnahme des Frequenzspektrums der Meßspannung sukzessive durchgestimmt. Der zur Geschwindigkeit der Frequenzdurchstimmung synchrone Zugriff auf die digitale Meßspannung über die erste Meßzeit erfolgt ebenfalls durch die übergeordnete Frequenz- und Abtaststeuereinheit 17. Die zu den einzelnen Meßfrequenzen innerhalb des Meßfrequenzbereiches erfaßten Spannungspegel des Meßsignals inklusive der identifizierten Funkstörspannungspegel werden im Speicher 18 zwischengespeichert.

Durch eine im Mikrorechner 14 integrierte übergeordnete Ablaufsteuerung, die in Fig. 1 nicht dargestellt ist, wird nach Ablauf der Vermessung des Frequenzspektrums der Meßspannung im gesamten Meßfrequenzbereich durch die Funktionseinheit Spektrum-Analysator 15 der Betrieb auf die Funktionseinheit Meßempfänger 16 umgeschaltet. In einem Meßfrequenzbereich der Funktionseinheit Meßempfänger 16, der im allgemeinen kleiner als der einstellbare Meßfrequenzbereich der Funktionseinheit Spektrum-Analysator 15 ist, findet in der Funktionseinheit Meßempfänger 16 eine genauere Analyse des Zeitverhaltens der einzelnen identifizierten Funkstörspannungen über mehrere Zugriffszeitpunkte im Rahmen einer zweiten Meßzeit statt. Die Meß- und Auswertungsergebnisse der Funktionseinheit Meßempfänger 16 werden ebenfalls im Speicher 18 zwischengespeichert.

Sämtliche Meßergebnisse werden in einer Darstellungseinrichtung 19, z. B. einem Display, in grafische oder tabellarischer Form zur Visualisierung und nachfolgenden Ergebnisdiskussion bereitgestellt.

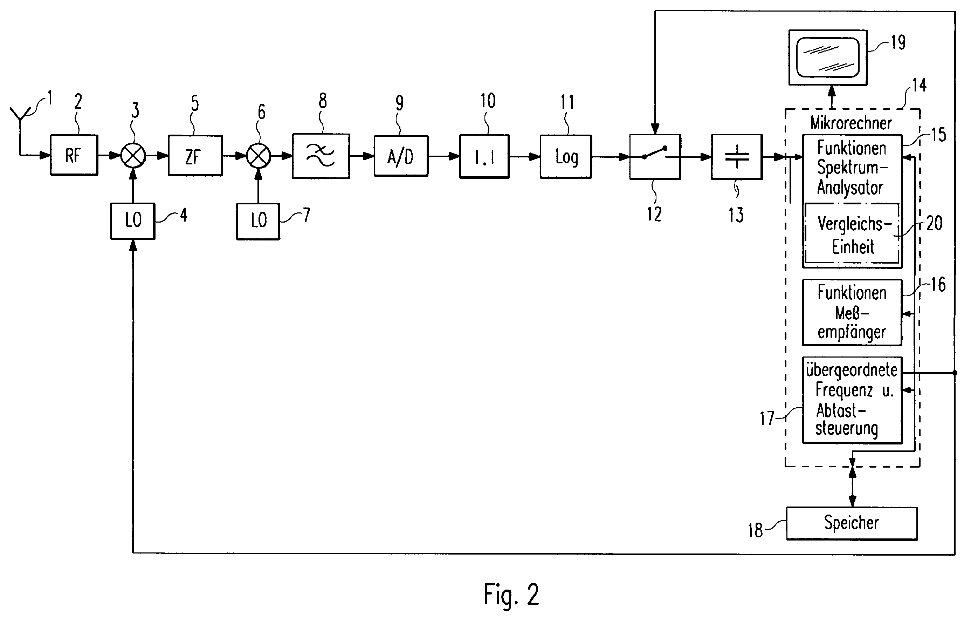

In Fig. 2 ist die zweite Ausführungsform der erfindungsgemäßen Vorrichtung zur Messung von Funkstörspannungen dargestellt. Zu technischen Merkmalen der ersten Ausführungsform in Fig. 1 identische technische Merkmale der zweiten Ausführungsform werden der Einheitlichkeit wegen in Fig. 2 mit identischen Bezugszeichen gekennzeichnet und im folgenden nicht wiederholt beschrieben.

Die zweite Ausführungsform der erfindungsgemäßen Vorrichtung zur Messung von Funkstörspannungen beinhaltet in Abgrenzung zur ersten Ausführungsform in Fig. 1 in der Funktions-Einheit Spektrum-Analysator 15 eine Vergleichs-Einheit 20 zum Vergleich jedes pro Meßfrequenz gemessenen Spannungspegels mit einem einstellbaren Schwellwert und zur Kennzeichnung des gemessenen Spannungspegels als Funkstörspannung im Falle eines Überschreitens des Schwellwertes durch den gemessenen Spannungspegel.

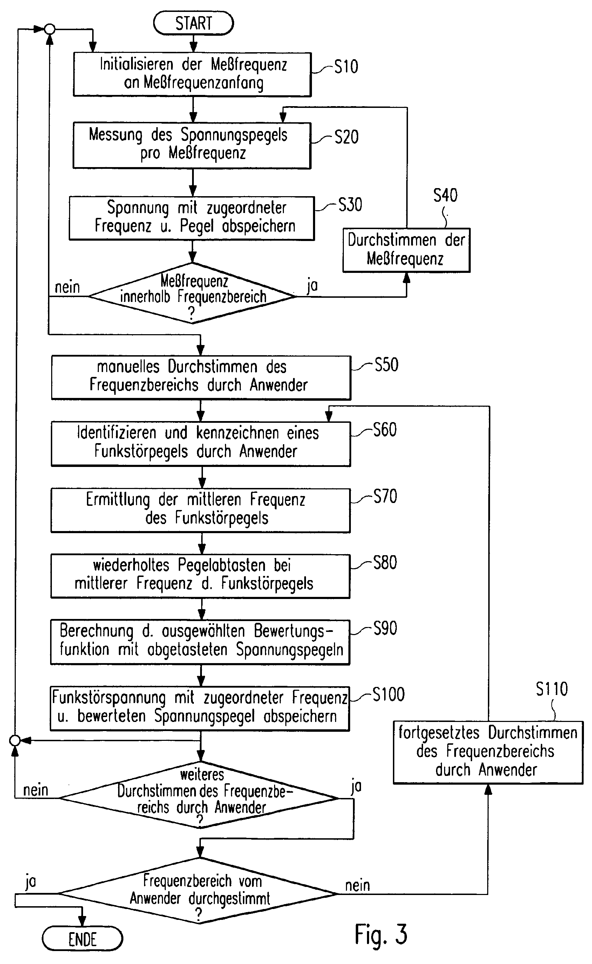

Die erste Ausführungsform des erfindungsgemäßen Verfahrens zur Messung von Funkstörpegeln, dessen Verfahrensschritte im Flußdiagramm in Fig. 3 dargestellt sind, führt in der beginnenden Vormessung, die von der Funktionseinheit Spektrum-Analysator 15 durchgeführt wird, im ersten Verfahrensschritt S10 eine Initialisierung der Meßfrequenz der erfindungsgemäßen Vorrichtung nach Fig. 1 z. B. mit der vom Anwender gewählten unteren Grenzfrequenz des zu vermessenden Meßfrequenzbereiches durch.

Im darauf folgenden Verfahrensschritt S20 wird bei der gewählten Meßfrequenz der Spannungspegel des aus der Funkstörspannung und überlagerter Rauschspannung bestehenden Meßspannung innerhalb einer ersten Meßzeit erfaßt.

Die im Verfahrensschritt S20 zur jeweiligen Meßfrequenz gemessenen Spannung wird mit ihrem dazugehörigen Spannungspegel und ihrer Meßfrequenz im Verfahrensschritt S30 abgespeichert.

Liegt der Wert der Meßfrequenz unterhalb der vom Anwender ausgewählten oberen Grenzfrequenz des zu vermessenden Meßfrequenzbereiches, so wird die Meßfrequenz um ein Frequenzrasterinkrement in Verfahrensschritt S40 erhöht und mit der neuen Meßfrequenz in Verfahrensschritt S20 eine neue Pegelmessung durchgeführt. Alternativ kann aber auch eine kontinuierliche (gesweepte) Messung durchgeführt werden.

Hat die eingestellte Meßfrequenz die vom Anwender ausgewählte obere Grenzfrequenz des zu vermessenden Meßfrequenzbereiches erreicht, so wird das zyklische Durchstimmen des Meßfrequenzbereichs mit Hilfe des Spektrum-Analysators 15 von neuem mit Verfahrensschritt S10 gestartet.

Sobald der gewünschte Meßfrequenzbereich mit dem Spektrum-Analysator 15 mindestens einmal durchgestimmt wurde und die zu den einzelnen Meßfrequenzen ermittelten Spannungspegel des zu untersuchenden Meßsignals erfaßt und abgespeichert wurden, ist es für den Anwender der erfindungsgemäßen Vorrichtung zur Messung von Funkstörpegeln möglich, soweit er dies beabsichtigt und noch nicht getan hat, in Verfahrensschritt S50 die manuelle Durchstimmung des gewünschten Meßfrequenzbereichs zu starten. Hierzu wird er die vom Spektrum-Analysator 15 in den Verfahrensschritten S10 bis S40 zyklisch aktualisierten Spannungspegel des zu untersuchenden Meßsignals, welche in der Darstellungs-Einrichtung 19 zu den einzelnen Meßfrequenzen ständig aktualisiert visualisiert werden, beispielsweise mit einem Cursor beginnend von der unteren Grenzfrequenz bis zur oberen Grenzfrequenz des Meßfrequenzbereiches sukzessive sichten und mit einem mental vom Anwender festgelegten Schwellwert vergleichen.

Führt der mental durchgeführte Vergleich zwischen dem jeweiligen gemessenen Spannungspegel des zu untersuchenden Meßsignals und dem Schwellwert für den Anwender zu der Erkenntnis, daß der gemessene Spannungspegel höher als der mental festgelegte Schwellwert ist, so wird der Anwender in Verfahrensschritt S60 diesen gemessenen Spannungspegel als Funkstörpegel identifizieren und als solchen für die erfindungsgemäße Vorrichtung zur Messung von Funkstörpegeln - beispielsweise durch Betätigung einer bestimmten Funktionstaste - kennzeichnen.

In Verfahrensschritt S70 ermittelt der Spektrum-Analysator 15 im Rahmen der Vormessung für den gekennzeichneten Funkstörpegel die zugehörige Meßfrequenz als Mittenfrequenz für eine spätere Nachmessung. Liegt ein breitbandiger Funkstörpegel vor, so wird von der Funktionseinheit Spektrum-Analysator 15 die jeweilige mittlere Meßfrequenz ermittelt und als Mittenfrequenz festgelegt.

Durch die übergeordnete Ablaufsteuerung des Mikrorechners 14 erfolgt nach der Ermittlung der zum jeweils identifizierten Funkstörpegel gehörigen mittleren Meßfrequenz eine Umschaltung von der Vormessung durch die Funktionseinheit Spektrum-Analysator 15 zur Nachmessung durch die Funktionseinheit Meßempfänger 16. Im darauffolgenden Verfahrensschritt S80 wird von einer Funktionseinheit Meßempfänger 16 eine über eine bestimmte einstellbare Anzahl von Zugriffszeitpunkten sich erstreckende zweite Meßzeit, die deutlich länger als die für den jeweiligen Meßpegel angesetzte erste Meßzeit der Funktionseinheit Spektrum-Analysator 15 ist, eine Messung des Spannungspegels des Meßsignals durchgeführt. Hierbei wird der Meßfrequenzbereich der Nachmessung so gewählt, daß die von der Funktionseinheit Spektrum-Analysator 15 für jeden gekennzeichneten Funkstörpegel ermittelte mittlere Meßfrequenz als Mittenfrequenz des jeweiligen Meßfrequenzbereichs für die Nachmessung benutzt wird.

Im darauf folgenden Verfahrensschritt S90 wird mit einer vom Anwender auswählbaren Berechnungsfunktion auf der Basis der zu den einzelnen Zugriffszeitpunkten gemessenen Spannungspegel des Meßsignals eine genauere Analyse des Zeitverhaltens der Funkstörpegels durchgeführt. Diese Analyse erstreckt sich auf den Meßfrequenzbereich der Funktionseinheit Meßempfänger 16 mit der von der Funktionseinheit Spektrum-Analysatoren 15 ermittelten Mittenfrequenz des jeweiligen Funkstörpegels als Mittenfrequenz des Meßfrequenzbereiches. Als Bewertungsfunktionen können hierbei beispielsweise folgende Funktionen vom Anwender ausgewählt werden:
- Sample-Funktion: Identifizierung des augenblicklichen Spannungspegels der Funkstörspannung,
- Max-peak-Funktion: Identifizierung des maximalen Spannungspegel der Funkstörspannung,
- Min-peak-Funktion: Identifizierung des minimalen Spannungspegel ist der Funkstörspannung,
- Quasi-peak-Funktion: Bewertung, die das Störvermögen des Signals bewertet,
- Average-Funktion: lineares Mitteln der abgetasteten Spannungspegel der Funkstörspannung und
- RMS-Funktion: quadratisches Mitteln der abgetasteten Spannungspegel der Funkstörspannung.

Im Verfahrensschritt S100 werden der durch die jeweils ausgewählte Bewertungsfunktion ermittelte Spannungspegelfunktionswert des jeweils identifizierten Funkstörpegels zusammen mit der ermittelten mittleren Meßfrequenz als Ergebnis einer genaueren Zeitanalyse des Funkstörpegels abgespeichert.

Nach Abspeichern des Meßergebnisses der Nachmessung durch die Funktionseinheit Meßempfänger 17 in Verfahrensschritt S100 wird wieder in die Vormessung zur Funktionseinheit Spektrum-Analysator 15 umgeschaltet und das Durchstimmen und Messen der zu den einzelnen Meßfrequenzen gehörigen Spannungspegel des zu untersuchenden Meßsignals mit Verfahrensschritt 10, wie in Fig. 3 durch die Rückführung angedeutet, wieder gestartet. Alternativ kann das Durchstimmen und Messen der einzelnen Spannungspegel bei den einzelnen Meßfrequenzen im Meßfrequenzbereich durch die Funktionseinheit Spektrum-Analysator 15 auch an einem anderen der Verfahrensschritte S10 bis S40 gestartet werden, wenn sich die Funktionseinheit Spektrum-Analysators 15 die Meßfrequenz der letzten Vormessung gemerkt hat.

Parallel zur Umschaltung in die Vormessung durch die übergeordnete Ablaufsteuerung des Mikrorechners 14 wird der Anwender, falls er sich für eine fortgesetzte manuelle Durchstimmung des gemessenen Meßfrequenzbereiches entscheidet und mit seiner manuellen Durchstimmung die obere Grenzfrequenz des Meßfrequenzbereiches noch nicht erreicht hat, den von der Funktionseinheit Spektrum-Analysator 15 kontinuierlich mit neu gemessenen Spannungspegeln des zu untersuchenden Meßsignals aktualisierten Meßfrequenzbereich durch Sichten des hinsichtlich seiner Meßfrequenz jeweils nächst höheren Spannungspegels in Verfahrensschritt S110 weiter manuell durchstimmen und mit seinem mental festgelegten Schwellwert vergleichen. Führt dieser mental durchgeführte Schwellwertvergleich zu einer Identifizierung eines weiteren Funkstörpegels, so wird in Verfahrensschritt S60 die obig beschriebene Kennzeichnung des Funkstörpegels durch den Anwender durchgeführt.

Erreicht der Anwender in seinem Durchstimm-Prozeß die obere Grenzfrequenz des gewünschten Meßfrequenzbereiches und hat er damit den gesamten Meßrequenzbereich nach möglicherweise vorliegenden Funkstörpegeln durchsucht, so ist das erfindungsgemäße Verfahren zur Messung von Funkstörpegeln abgeschlossen.

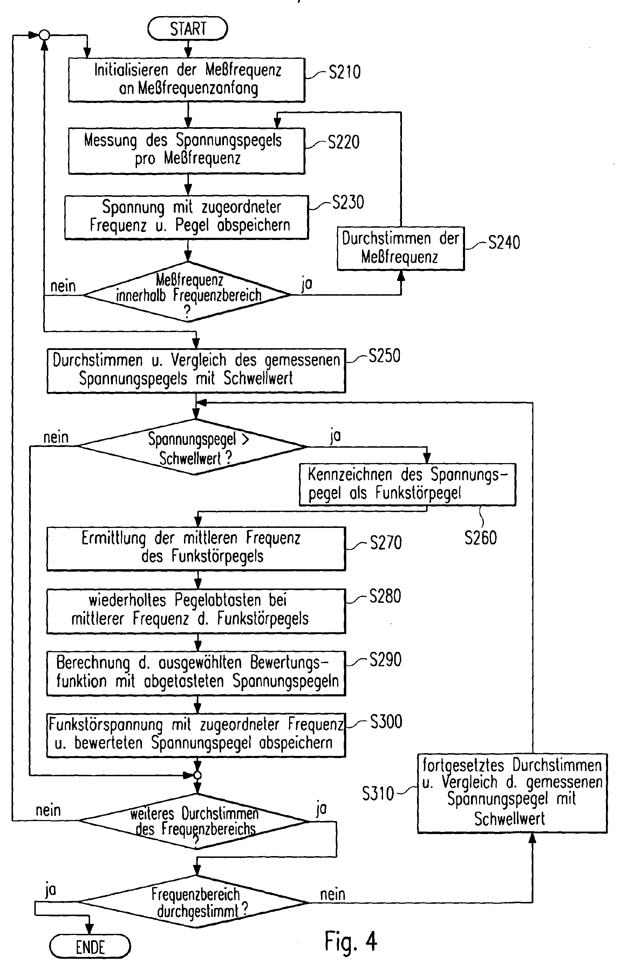

In Fig. 4 ist die zweite Ausführungsform des erfindungsgemäßen Verfahrens zur Messung von Funkstörpegeln dargestellt. Die Verfahrensschritte S210 bis S240 bzw. S270 bis S310 der zweiten Ausführungsform des erfindungsgemäßen Verfahrens zur Messung von Funkstörpegeln in Fig. 4 entsprechen den Verfahrensschritten S10 bis S40 bzw. S70 bis S110 der ersten Ausführungsform des erfindungsgemäßen Verfahrens zur Messung von Funkstörpegeln und werden deshalb nicht wiederholt beschrieben.

In der zweiten Ausführungsform des erfindungsgemäßen Verfahrens wird das Durchstimmen und Identifizieren von Funkstörpegeln im gewünschten Meßfrequenzbereich nicht vom Anwender sondern automatisiert durch die Funktionseinheit Spektrum-Analysator 15 bzw. dessen Unterfunktionseinheit Vergleichs-Einheit 20 durchgeführt. Hierzu wird der Spektrum-Analysator 15 in Verfahrensschritt S250 auf Kommando des Anwenders - beispielsweise durch Betätigung einer bestimmten Funktionstaste - nach mindestens einmaliger Messung und Visualisierung der einzelnen Spannungspegel des zu untersuchenden Meßsignals gestartet. Für das Durchstimmen des gewünschten Meßfrequenzbereichs wird der Spektrum-Analysator in Analogie zu Verfahrensschritt S210 mit der unteren Grenzfrequenz des vom Anwender gewünschten Meßfrequenzbereiches initialisiert und anschließend der in den Verfahrensschritten S210 bis S240 jeweils gemessene Spannungspegel des zu untersuchenden Meßsignals mit einem Schwellwert verglichen. Bei dem Schwellwert handelt es sich üblicherweise um einen über den ganzen Meßfrequenzbereich konstanten Wert, der im Sinne eines Markers über den gesamten Meßfrequenzbereich gelegt wird. Prinzipiell ist aber auch die Verwendung eines über den gesamten Meßfrequenzbereich veränderlichen Schwellwertverlaufs möglich.

Ergibt der Schwellwertvergleich, daß der jeweils gemessene Spannungspegel den Schwellwert übersteigt und somit ein Funkstörpegel vorliegt, so wird in Verfahrensschritt S260 der jeweilige Spannungspegel von der Funktionseinheit Spektrum-Analysator 15 als Funkstörpegel gekennzeichnet und auf die Messung der zugehörigen Meßfrequenz in Verfahrensschritt S270 übergegangen.

Ergibt der Schwellwertvergleich, daß der jeweils gemessene Spannungspegel kein Funkstörpegel darstellt, so wird im Fall, daß der Anwender ein fortgesetztes Durchstimmen und Identifizieren von Funkstörpegeln im gewünschten Meßfrequenzbereich wünscht - beispielsweise durch Betätigung einer bestimmten Funktionstaste - und die obere Grenzfrequenz des Meßfrequenzbereiches noch nicht erreicht ist, der Durchstimm- und Suchprozeß des Spektrum-Analysators 15 nach möglichen Funkstörpegeln in Verfahrensschritt S310 fortgesetzt. Wird vom Anwender kein fortgesetztes Durchstimmen und Identifizieren von Funkstörpegeln gewünscht, so wird wieder in der originären Messung der einzelnen Spannungspegel des zu untersuchenden Meßsignals in Verfahrensschritt S210 oder alternativ, falls sich der Spektrum-Analysator 15 die Meßfrequenz des in der Vormessung zuletzt gemessenen Spannungspegels gemerkt hat, in einem der Verfahrensschritte S20 bis S40 fortgefahren. Liegt vom Anwender ein Wunsch zum fortgesetzten Durchstimmen und Identifizieren von Funkstörpegeln vor und hat die Funktionseinheit Spektrum-Analysator 15 im Rahmen dieses Durchstimm- und Identifizierungsprozesses die obere Grenzfrequenz des gewünschten Messfrequenzbereiches erreicht und ist somit der gesamte Meßfrequenzbereich nach möglicherweise vorliegenden Funkstörpegeln abgesucht, so ist das erfindungsgemäße Verfahren zur Funkstörpegeln abgeschlossen.

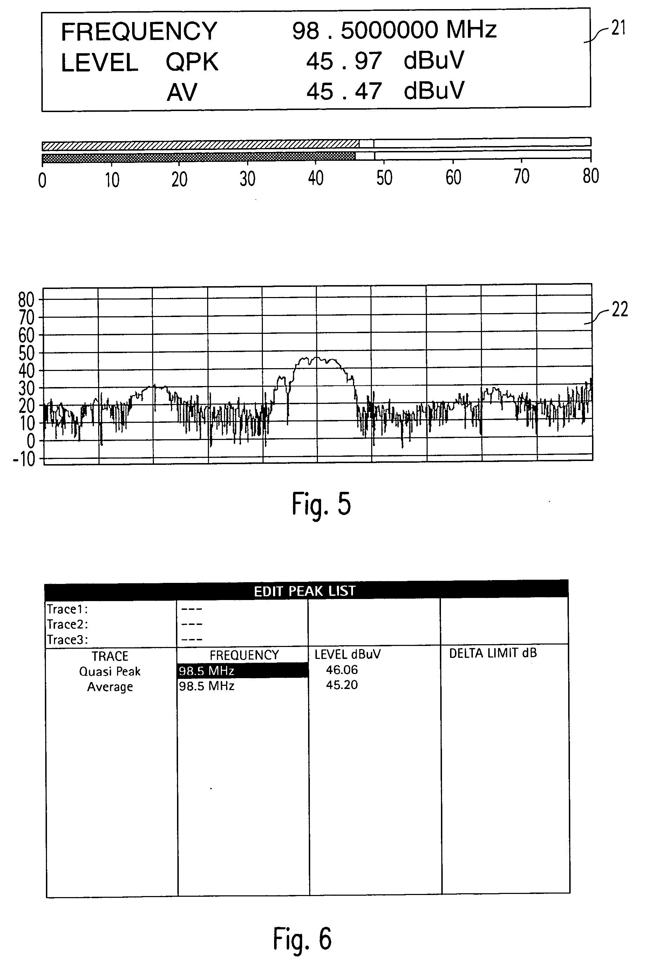

In Fig. 5 ist eine grafische Darstellung eines beispielhaften Meßergebnisses einer Messung von Funkstörpegeln, wie sie auf einer Darstellungseinrichtung 19 dargeboten wird, dargestellt. Im oberen Bereich 21 der Darstellung, der den Ergebnissen der Nachmessung reserviert ist, werden bei einer ermittelten Mittenfrequenz von im Beispiel ca. 98,5 MHz für eine identifizierte Funkstörspannung die Spannungspegelwerte und Frequenzwerte bei Verwendung der Quasi-Peak- und der Average-Funktion als Bewertung dargestellt. Im unteren Bereich 22 der Darstellung ist das Frequenzspektrum der Funkstörspannung inklusive der benachbarten Rauschspannung im Meßfrequenzbereich der Funktionseinheit Spektrum-Analysatoren 15 mit der ermittelten Mittenfrequenz der Funkstörspannung als Mittenfrequenz des verwendeten Meßfrequenzbereiches dargestellt. Analog können für die übrigen identifizierten Funkstörspannungen die Ergebnisse der Vor- und Nachmessung dargestellt werden. In dem unteren Bereich 22 könnten auch der spektrale Verlauf der Bewertungsfunktion, im Beispiel Quasi-Peak und Average, zusätzlich dargestellt werden.

In Fig. 6 ist eine tabellarische Darstellung eines beispielhaften Meßergebnisses einer Messung von Funkstörpegeln - identisch zum beispielhaften Meßergebnis in Fig. 5 - dargestellt. Auch in der Darstellung in Fig. 6 wurde die Quasi-Peak und die Average-Funktion jeweils als Bewertungsfunktionen benutzt. Die Tabelle gibt den durch die jeweilige Bewertungsfunktion ermittelten Spannungspegelfunktionswert und die zugehörige Meßfrequenz wieder.

Die Erfindung ist nicht auf die beiden beschriebenen Ausführungsformen beschränkt. Sämtliche beschriebene Funktionen und Elemente können beliebig miteinander kombiniert werden.

## Patentansprüche

1. Verfahren zur Messung von Funkstörpegeln in einem bestimmten Meßrequenzbereich, indem in einer Vormessung der Meßfrequenzbereich zyklisch durchgestimmt und bei jeder Meßfrequenz jeweils ein Meßpegel des zu vermessenden Signals erfaßt wird und für den Fall einer Identifizierung eines Funkstörpegels in den gemessenen Meßpegeln die Vormessung durch eine Nachmessung unterbrochen wird, in der der jeweils identifizierte Funkstörpegel hinsichtlich seines Zeitverhaltens genauer vermessen wird,
wobei die Identifizierung jedes Funkstörpegels asynchron zur zyklischen Durchstimmung und Messung der Meßpegel des Meßfrequenzbereiches erfolgt,
wobei die Identifizierung des Funkstörpegels eine abschließende Ermittlung der zugehörigen mittleren Frequenz beinhaltet,
**dadurch gekennzeichnet,**
**daß** die Mittenfrequenz des Meßfrequenzbereichs der zum jeweils identifizierten Funkstörpegel gehörigen Nachmessung an die in der vorhergehenden Vormessung ermittelte mittlere Frequenz des Funkstörpegels nachgeführt wird.

2. Verfahren zur Messung von Funkstörpegeln nach Anspruch 1,
**dadurch gekennzeichnet,**
**daß** zur Identifizierung des jeweiligen Funkstörpegels ein Vergleich des jeweils gemessenen Meßpegels des zu vermessenden Signals mit einem Schwellwert erfolgt.

3. Verfahren zur Messung von Funkstörpegeln nach Anspruch 2,
**dadurch gekennzeichnet,**
**daß** bei Überschreiten des Schwellwerts durch den jeweils gemessenen Meßpegel der jeweils gemessene Meßpegel als Funkstörpegel identifiziert wird.

4. Verfahren zur Messung von Funkstörpegeln nach Anspruch 2 oder 3,
**dadurch gekennzeichnet,**
**daß** die Identifizierung des jeweiligen Funkstörpegels manuell durch den Anwender oder automatisiert erfolgt.

5. Verfahren zur Messung von Funkstörpegeln nach einem der Ansprüche 1 bis 4,
**dadurch gekennzeichnet,**
**daß** der Meßfrequenzbereich bei der Vormessung in einem bestimmten Frequenzraster durchgestimmt wird.

6. Verfahren zur Messung von Funkstörpegeln nach einem der Ansprüche 1 bis 5,
**dadurch gekennzeichnet,**
**daß** der Meßpegel des jeweiligen Funkstörpegels in der Nachmessung mehrfach wiederholt gemessen wird.

7. Verfahren zur Messung von Funkstörpegeln nach Anspruch 6,
**dadurch gekennzeichnet,**
**daß** aus den bei der Nachmessung mehrfach gemessenen Meßpegeln für jeden identifizierten Funkstörpegel ein nach einem aus mehreren einstellbaren Bewertungsverfahren bewerteter Pegel ermittelt wird.

8. Vorrichtung zur Messung von Funkstörpegeln, wobei die Vorrichtung eine Funktionseinheit Spektrum-Analysator (15) zur Durchstimmung des gesamten Meßfrequenzbereiches, Messung des jeweiligen Meßpegels des zu vermessenden Signal bei jeder Meßfrequenz und Ermittlung der mittleren Frequenz der identifizierten Funkstörpegel im Rahmen einer Vormessung und eine Funktionseinheit Meßempfänger (16) zur mehrfachen Messung der Meßpegel der von der Funktionseinheit Spektrum-Analysator (15) identifizierten Funkstörpegel und zur statistischen Bewertung der gemessenen Meßpegel im Rahmen einer Nachmessung aufweist,
**dadurch gekennzeichnet,**
**dass** die Vorrichtung Mittel zur Durchführung der Schritte des Verfahrens nach einem der Ansprüche 1 bis 7 aufweist.

9. Vorrichtung zur Messung von Funkstörpegeln nach Anspruch 8,
**dadurch gekennzeichnet,**
**daß** die Funktionseinheit Spektrum-Analysator (15) zusätzlich eine Vergleichs-Einheit (20) enthält, die eine Identifizierung von Funkstörpegeln durch Vergleich jedes gemessenen Meßpegels mit einem Schwellwert durchführt.

## Claims

1. Method for measuring radio interference levels in a particular measurement frequency range by cyclically sweeping through the measurement frequency range in a preliminary measurement and detecting a measurement level of the signal to be measured at each measurement frequency and in the event of identifying a radio interference level in the measured measurement levels interrupting the preliminary measurement with a following measurement in which the identified radio interference level is measured more precisely with respect to its time characteristic, wherein the identification of each radio interference level is carried out asynchronously to the cyclical sweep through and measurement of the measurement levels of the measurement frequency range,
wherein the identification of the radio interference level includes a final determination of the associated mean frequency,
**characterised in that**
the mean frequency of the measurement frequency range of the following measurement associated with the particular identified radio interference level is adjusted to the mean frequency of the radio interference level determined in the preceding preliminary measurement.

2. Method for measuring radio interference levels according to claim 1,
**characterised in that**
to identify the respective radio interference level a comparison is made of the particular measured measurement level of the signal to be measured with a threshold value.

3. Method for measuring radio interference levels according to claim 2,
**characterised in that**
if the particular measured measurement level exceeds the threshold value, the particular measured measurement level is identified as the radio interference level.

4. Method for measuring radio interference levels according to claim 2 or 3,
**characterised in that**
the identification of the particular radio interference level is carried out manually by the user or automated.

5. Method for measuring radio interference levels according to one of claims 1 to 4,
**characterised in that**
in the preliminary measurement the measurement frequency range is swept through in a particular frequency raster.

6. Method for measuring radio interference levels according to one of claims 1 to 5,
**characterised in that**
the measurement level of the particular radio interference level is measured repeatedly multiple times in the following measurement.

7. Method for measuring radio interference levels according to claim 6,
**characterised in that**
a level evaluated by one of a plurality of selectable evaluation methods is determined from the measurement levels measured multiple times during the following measurement for each identified radio interference level.

8. Device for measuring radio interference levels,
wherein the device exhibits a spectrum analyser function unit (15) for sweeping through the entire measurement frequency range, measuring the particular measurement level of the signal to be measured at each measurement frequency, and determining the mean frequency of the identified radio interference levels in a preliminary measurement, and a measurement receiver function unit (16) for measuring multiple times the measurement levels of the radio interference levels identified by the spectrum analyser function unit (15) and for statistically evaluating the measured measurement levels in a following measurement,
**characterised in that**
the device exhibits means for carrying out the steps of the method according to one of claims 1 to 7.

9. Device for measuring radio interference levels according to claim 8,
**characterised in that**
the spectrum analyser function unit (15) additionally contains a comparison unit (20) which identifies radio interference levels by comparing each measured measurement level with a threshold value.

## Revendications

1. Procédé de mesure de niveaux de perturbation radio dans une plage de fréquence de mesure, dans lequel, dans une pré-mesure de la plage de fréquence de mesure, un accordage est effectué de manière cyclique et, pour chaque fréquence de mesure, un niveau de mesure du signal à mesurer est déterminé et, pour le cas d'une identification d'un niveau de perturbation radio dans les niveaux de mesure mesurés, la pré-mesure est interrompue par une post-mesure, dans laquelle le niveau de perturbation radio identifié est mesuré en ce qui concerne son comportement dans le temps,
l'identification de chaque niveau de perturbation radio ayant lieu de manière asynchrone par rapport à l'accordage cyclique et à la mesure du niveau de mesure de la plage de fréquence de mesure,
l'identification du niveau de perturbation radio contenant une détermination finale de la fréquence moyenne correspondante,
**caractérisé en ce que**
la fréquence centrale de la plage de fréquence de mesure de la post-mesure appartenant au niveau de perturbation radio identifié est asservie à la fréquence moyenne du niveau de perturbation radio déterminé dans la pré-mesure précédente.

2. Procédé de mesure de niveaux de perturbations radio selon la revendication 1,
**caractérisé en ce que**
pour l'identification du niveau de perturbation radio, une comparaison du niveau de mesure mesuré du signal à mesurer a lieu avec une valeur seuil.

3. Procédé de mesure de niveaux de perturbations radio selon la revendication 2,
**caractérisé en ce que**
lors d'un dépassement de la valeur seuil par le niveau de mesure mesuré, le niveau de mesure mesuré est identifié comme un niveau de perturbation radio.

4. Procédé de mesure de niveaux de perturbations radio selon la revendication 2 ou 3,
**caractérisé en ce que**
l'identification du niveau de perturbation radio est accordé lors de la pré-mesure dans une gamme de fréquences déterminée.

5. Procédé de mesure de niveaux de perturbations radio selon l'une des revendications 1 à 4,
**caractérisé en ce que**
la plage de fréquence de mesure est accordée lors de la pré-mesure dans une gamme de fréquences déterminée.

6. Procédé de mesure de niveaux de perturbations radio selon l'une des revendications 1 à 5,
**caractérisé en ce que**
le niveau de mesure du niveau de perturbation radio est mesuré de manière répétitive plusieurs fois dans la post-mesure.

7. Procédé de mesure de niveaux de perturbations radio selon la revendication 6,
**caractérisé en ce que**
à partir des niveaux de mesure plusieurs fois mesurés lors de la post-mesure, pour chaque niveau de perturbation radio, un niveau, évalué selon plusieurs procédés d'évaluation réglables, est déterminé.

8. Dispositif de mesure de niveaux de perturbations radio, le dispositif comprenant une unité fonctionnelle de type analyseur de spectre (15) pour l'accordage de l'ensemble de la plage de fréquences de mesure, la mesure du niveau de mesure correspondant du signal à mesurer pour chaque fréquence de mesure et la détermination de la fréquence moyenne des niveaux de perturbations radio identifiés dans le cadre d'une pré-mesure et une unité fonctionnelle de type récepteur de mesure (16) pour la mesure multiple du niveau de mesure du niveau de perturbation radio identifié par l'unité fonctionnelle de type analyseur de spectre (15) et pour l'évaluation statistique du niveau de mesure mesuré dans le cadre d'une post-mesure,
**caractérisé en ce que**
le dispositif comprend des moyens pour la réalisation des étapes du procédé selon l'une des revendications 1 à 7.

9. Dispositif de mesure de niveaux de perturbations radio selon la revendication 8,
**caractérisé en ce que**
l'unité fonctionnelle de type analyseur de spectre (15) comprend en outre une unité de comparaison (20) qui effectue une identification des niveaux de perturbations radio par comparaison de chaque niveau de mesure mesuré avec une valeur seuil.
